# EUROPÄISCHE PATENTSCHRIFT

(11) **EP 0 893 764 B1**
(45) Veröffentlichungstag und Bekanntmachung des Hinweises auf die Patenterteilung: **05.04.2006**
(21) Anmeldenummer: 98202368.1
(22) Anmeldetag: 15.07.1998
(51) Int. Cl.: G06F 12/14, G11C 16/06, G11C 29/00

(54) **Integrierte Schaltung mit programmierbarer Verriegelungsschaltung**
Integrated circuit with programmable latch circuit
Circuit intégré avec circuit de bascule programmable

(30) Priorität: 22.07.1997 DE 19731406
(43) Veröffentlichungstag der Anmeldung: 27.01.1999
(73) Patentinhaber: Philips Intellectual Property & Standards GmbH, 20099 Hamburg (DE); Koninklijke Philips Electronics, N.V., 5621 BA Eindhoven (NL)
(72) Erfinder: Rzittka, Eckart, Röntgenstrasse 24, 22335 Hamburg (DE)
(74) Vertreter: Peters, Carl Heinrich

(56) Entgegenhaltungen:
- FR-A- 2 656 145
- US-A- 5 175 840

## Beschreibung

Die Erfindung bezieht sich auf eine integrierte Schaltung mit programmierbarer Verriegelungsschaltung zur Generierung eines nach Programmierung nicht umkehrbar geänderten Schaltsignals mit wenigstens zwei EEPROM-Zellen, deren Ausgangssignale nach einer EXOR-Verknüpfung das Schaltsignal ergeben.

Die Sicherheit von Datenbeständen in integrierten Schaltungen wird durch Verriegelungsschaltungen geschützt. Es wird sichergestellt, daß nach einer Programmierung keine Daten aus der integrierten Schaltung gelesen oder darin manipuliert werden können.

Aus Druckschrift FR-A-2 656 145, auf welcher der Oberbegriff des Anspruchs 1 basiert, sind programmierbare Verriegelungsschaltungen bekannt.

Aus US-PS 51 75 840 ist eine Anordnung bekannt, mit der EEPROM-Zellen getestet werden und die Zellen für unautorisierten Zugriff blockiert werden können. Der externe Datenaustausch wird über ein Sicherheitssignal gesteuert. In einem Zustand des Sicherheitssignals ist ein Lesen und Schreiben der Daten von außen möglich. Der entgegengesetzte Zustand verhindert den externen Datenaustausch. Eine erste Bedingung, die über den Zustand des Sicherheitssignals entscheidet, wird aus den Zuständen von Sicherheits-EEPROM-Zellen gebildet. Wenn die Zustände dieser Sicherheits-EEPROM-Zellen alle gleich sind, nimmt das Sicherheitssignal nach einer ENOR-Verknüpfung einen Zustand an, der den externen Datenaustausch ermöglicht. Gleiche Zustände dieser Zellen liegen nur vor, wenn vorher alle Zellen gelöscht oder gesetzt wurden. Diese Zustände lassen sich von außen einstellen. Durch eine zweite Bedingung wird das Sicherheitssignal permanent so eingestellt, daß ein externer Datenaustausch nicht mehr möglich ist. Ist eine oder sind beide der genannten Bedingungen erfüllt, nimmt das Sicherheitssignal einen Zustand an, bei dem kein externer Datenaustausch möglich ist.

Wenn das Sicherheitssignal einen externen Datenaustausch ermöglicht, befindet sich die Anordnung in einem Testmodus, in dem sich die Daten der EEPROM-Zellen von außen auslesen und neu beschreiben lassen.

Das Sicherheitssignal läßt sich umkehren, solange die Lösch- und Schreibmodi für die Sicherheits-EEPROM-Zellen von außen eingestellt werden können, so daß bei Kenntnis der Struktur und Programme eine Umkehr des Sicherheitssignals auch für nicht berechtigte Personen möglich ist. Erst nachdem von außen eine definierte Programmierspannung an einen bestimmten Anschluß angelegt wurde, wird das Sicherheitssignal unumkehrbar, und die EEPROM-Daten in der integrierten Schaltung können von außen nicht mehr verändert werden. Wenn diese Spannung nicht angelegt wird, bleibt die Anordnung immer in einem Zustand, in dem das Sicherheitssignal wieder rückgesetzt werden kann.

Der Erfindung liegt die Aufgabe zugrunde, eine Verriegelungsschaltung anzugeben, mit der ein nicht mehr umkehrbares Schaltsignal erzeugt wird.

Diese Aufgabe wird durch eine integrierte Schaltung mit programmierbarer Verriegelungsschaltung der eingangs genannten Art dadurch gelöst, daß die EEPROM-Zellen nur gleichzeitig derart programmierbar sind, daß eine Zelle beschrieben und eine andere gelöscht wird.

Dazu wird bei der Anordnung von einem Ausgangszustand ausgegangen, bei dem die EEPROM-Zellen noch nicht programmiert sind und gleiche Zustände haben. Bei diesem Ausgangszustand kann mit einem Programmierimpuls das Schaltsignal so eingestellt werden, daß es einen Zustand annimmt, der eine Verriegelung darstellt. Hervorzuheben ist dabei, daß nur programmiert werden muß und das Ergebnis der Programmierung durch die Verschaltung der Zellen eindeutig festgelegt ist. Auch durch eine Veränderung der Control-Gate-Spannung ist es nach dem Programmieren nicht mehr möglich, den Ausgangszustand, in dem die Zellen noch die unverschobene, herstellungsbedingt gleiche Schwellspannung haben, wiederherzustellen und das Schaltsignal, mit dem verriegelt werden soll, wieder umzukehren.

Die Ausführungsbeispiele der Erfindung werden nachstehend anhand der Zeichnungen näher erläutert. Es zeigen:
- Fig. 1: ein Blockschaltbild für das Funktionsprinzip und
- Fig. 2: ein Schaltbild für die erfindungsgemäße Verriegelungsschaltung.

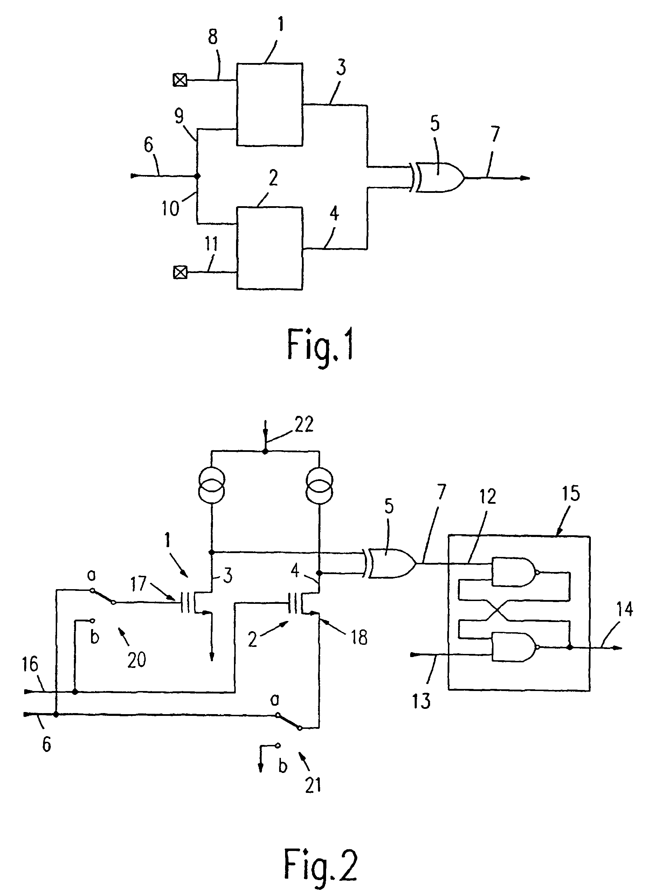

Das in Fig. 1 dargestellte Blockschaltbild zeigt die beiden antiparallel programmierbaren Zellen 1 u.2, deren Ausgänge 3 u.4 einem EXOR-Gatter 5 zugeführt werden. Die beiden Zellen sind so mit dem Programmiereingang 6 verbunden, daß bei Zelle 1 nur der Schreibeingang 9 und bei Zelle 2 nur der Löscheingang 10 angeschlossen sind. Die jeweils entgegengesetzten Eingänge 8 u. 11, bei Zelle 1 der Löscheingang 8 und bei Zelle 2 der Schreibeingang 11, sind nicht angeschlossen. Am Ausgang des EXOR liegt das Schaltsignal 7 vor. Durch diese Anschlußweise der Zellen liegt nach dem ersten Progranunierimpuls eine "1" am Ausgang 7, und die zu sichernde Schaltung, die nicht dargestellt ist, wird unumkehrbar verriegelt.

Fig. 2 zeigt eine mögliche Realisierung dieser Verriegelungsschaltung. Sie besteht aus zwei EEPROM-Zellen 1 u.2, deren die Ausgänge 3 u.4 darstellenden Drains über eine Betreibsspannung VDD 22 stromgespeist werden und mit den Eingängen des EXOR 5 verbunden sind. Zwei Schalter 20 u.21 verbinden in Schalterstellung a das Gate 17 der Zelle 1 und die Source 18 der Zelle 2 mit dem Programmiereingang 6. In Schalterstellung b werden das Gate 17 der Zelle 1 mit der Control-Gate-Spannung 16 und die Source 18 der Zelle 2 mit dem Bezugspotential verbunden. Der Ausgang 7 des EXOR 5 ist der Set-Eingang 12 des Flip-Flops 15. Das Flip-Flop ist mit NAND-Gattern realisiert und hat den Ausgang 14. Der Reset-Eingang 13 ist mit einem Power-Up-Signal verbunden.

Zwei gleich aufgebaute benachbarte EEPROM-Zellen haben im unprogrammierten Zustand, herstellungsbedingt, annähernd die gleiche Schwellspannung und liefern gleiche Ausgangssignale, die dem EXOR zugeführt werden und am Ausgang des EXOR eine Null ergeben. Dieser Zustand stellt den Ausgangszustand dar. Durch ein Anlegen einer Lesespannung von 3 V an die Controlgates wird dies überprüft. Möglicherweise liegt die Schwellspannung der beiden Zellen genau im Umschaltpunkt, und die Zellen liefern im unprogrammierten Zustand unterschiedliche Ausgangssignale. Das würde zu einer "1" am Ausgang des EXOR führen und eine Verriegelung darstellen. Um dies zu verhindern, wird der oben erwähnte Ausgangszustand eingestellt. Dazu werden die Schalter 20 u. 21 in Stellung b gebracht und die Control-Gate-Spannung 16 der Speicherzellen verändert. Da sich aufgrund des Koppelfaktors zwischen Control-Gate und Floating-Gate auch die Schwellspannung verschiebt, wird die Control-Gate-Spannung von beispielsweise 3V auf 1V umgeschaltet, um die Schwellspannung so weit zu verschieben, daß ein Bereich mit gleichen Ausgangssignalen bei beiden Zellen durchlaufen wird. Dieser Ausgangszustand muß sicher herbeigeführt werden. Der Ausgangzustand wird durch eine "0" nach dem EXOR dargestellt und im Flip-Flop 15 zwischengespeichert. Die Speicherung dieses Schaltsignals 7 im Flip-Flop 15 ist insbesondere erforderlich, falls die Speicherzellen 1 u.2 über eine Adressierung angesprochen werden und das Schaltsignal 7 nicht dauerhaft am Ausgang des EXOR 5 anliegt.

Nachdem der Ausgangszustand bei den Zellen überprüft bzw. eingestellt wurde, d.h. am Ausgang 14 eine "0" anliegt, erfolgt die Programmierung. Der Ausgangszustand, repräsentiert durch eine "0" am Ausgang 14, wird so lange gehalten, bis bei erneutem Einschalten der Betriebsspannung das Flip-Flop 15 über den Reset-Eingang 13 mit einem Power-Up-Signal zurückgesetzt wird, da nach der Programmierung der Zellen 1 u.2, das EXOR 5 immer eine "1 " am Ausgang 7 und Set-Eingang 12 bekommt und damit das Flip-Flop 15 nicht mehr auf "0" zurückgesetzt werden kann.

Im Programmiermodus wird ein Programmierimpuls am Gate 17 der Zelle 1 und an der Source 18 der anderen Zelle 2 angelegt. Dadurch werden die Zellen entgegesetzt programmiert. Zelle 1 wird beschrieben und Zelle 2 gelöscht.

Neben diesem Programmiermodus, der in Fig.2 durch die Schalterstellung a charakterisiert wird, gibt es noch einen Lesemodus. In diesem Lesemodus werden beide Zellen gleich angesteuert, dazu sind die Schalter 21 u. 22 in die Stellung b zu bringen. In diesem Lesemodus kann durch ein Auslesen der eingeschriebenen Zustände die Stabilität der Zustände der Zellen nach erfolgtem Programmierimpuls überprüft werden. Normalerweise wird mit einer Spannung von 3V der Zustand aus den EEPROM-Zellen ausgelesen. Um möglichen indifferenten Zuständen vorzubeugen, wird durch veränderte Lesespannungen geprüft, ob die Zellen ihre programmierten Zustände mit den entsprechenden Ausgangssignalen beibehalten. Dazu werden an die Control-Gates der Zellen Spannungen von 5V und 0V angelegt. Zelle 1 ist beschrieben und wird mit 0V angesteuert, um zu überprüfen, ob die Zelle ihr Ausgangssignal beibehält. Eine Spannung von 0V an der gelöschten Zelle 2 bewirkt keine Veränderung. Zelle 2 wird mit 5 V angesteuert. Das Ausgangssignal der Zelle muß erhalten bleiben. An dem Ausgangssignal der beschriebenen Zelle 1 ändern 5 V nichts. Die Prüfung erfolgt nach dem Programmieren und vor dem Abschalten der Spannung.

Die Verriegelung tritt nach erfolgtem Programmierimpuls und einem erneuten Einschalten der Betriebsspannung ein, da das Flip-Flop 15 jetzt immer eine "1" am Ausgang 14 ausgibt. Es kann nur durch eine "0" am Set- Eingang, die jetzt nicht mehr auftreten kann, auch am Ausgang 14 auf "0" zurückgesetzt werden.

Vorteil dieser Verriegelungsschaltung ist, daß nach einmaligem Programmierimpuls das Schaltsignal nicht mehr umgekehrt werden kann. Bei jedem neuen Programmieren bleibt die Verriegelung bestehen, weil, nachdem das Flip-Flop zurückgesetzt wurde, das Schaltsignal am EXOR wieder "1" ist und auch am Ausgang 14 das Schaltsignal eine Verriegelung anzeigt.

Durch die Überprüfung der Stabilität der einprogrammierten Zustände wird eine zusätzliche Sicherheit der Verriegelungsschaltung gewährleistet.

## Patentansprüche

1. Integrierte Schaltung mit programmierbarer Verriegelungsschaltung zur Generierung eines nach Programmierung nicht umkehrbar geänderten Schaltsignals mit wenigstens zwei EEPROM-Zellen (1, 2), deren Ausgangssignale nach einer EXOR-Verknüpfung (5) das Schaltsignal ergeben, wobei die EEPROM-Zellen (1, 2) nur gleichzeitig derart programmierbar sind, daß eine Zelle (1) beschrieben und eine andere (2) gelöscht wird,
**dadurch gekennzeichnet, daß** vor dem Programmieren eine Control-Gate-Spannung (16), die jeweils an einem Control-Gate beider EEPROM-Zellen (1,2) anliegt, verändert wird, bis gleiche Ausgangssignale beider EEPROM-Zellen (1, 2) herbeigeführt sind, und daß das so erreichte Schaltsignal in einer Speicherzelle (15) zwischengespeichert wird.

2. Integrierte Schaltung mit programmierbarer Verriegelungsschaltung nach Anspruch 1,
**dadurch gekennzeichnet, daß** nach dem Programmieren bei Anlegen unterschiedlicher Control-Gate-Spannungen (16) von beiden Zellen (1, 2) unterschiedliche Ausgangssignale abgegeben werden.

3. Integrierte Schaltung mit programmierbarer Verriegelungsschaltung nach Anspruch 1,
**dadurch gekennzeichnet, daß** das Schaltsignal in der Speicherzelle (15) zwischengespeichert und das Ausgangssignal der Speicherzelle (15) ausgewertet wird und die Speicherzelle (15) nach jedem Einschalten der Betriebsspannung zurückgesetzt wird.

4. Integrierte Schaltung mit programmierbarer Verriegelungsschaltung nach Anspruch 1,
**dadurch gekennzeichnet, daß** zum Programmieren gleichzeitig eine Zelle (1) am Gate (17) und eine andere (2) an Source (18) mit einem beliebigen Programmierimpuls angesteuert werden.

5. Tragbarer Datenträger mit einer integrierten Schaltung nach Anspruch 1, der Bereiche mit zu schützenden Daten enthält, auf die der Zugriff von außerhalb des Datenträgers durch die programmierte Verriegelungsschaltung dauerhaft verhindert ist.

## Claims

1. An integrated circuit with a programmable locking circuit for the generation of an irreversibly changed switching signal after programming, comprising at least two EEPROM cells (1, 2) whose output signals produce the switching signal after an EXOR operation (5), wherein the EEPROM cells (1, 2) are only programmable at the same time in such a manner that one cell (1) is written in and another cell (2) is erased,
**characterized in that** a control gate voltage (16) is changed before programming, which control gate voltage (16) is applied to a control gate of both EEPROM cells (1, 2), until equal output voltages of the two EEPROM cells (1, 2) have been established, and **in that** the switching signal thus achieved is buffered in a memory cell (15).

2. An integrated circuit with a programmable locking circuit as claimed in Claim 1, **characterized in that** after programming different output signals are supplied by the two cells (1, 2) upon the application of different control gate voltages (16).

3. An integrated circuit with a programmable locking circuit as claimed in Claim 1, **characterized in that** the switching signal is buffered in the memory cell (15), and the output signal of the memory cell (15) is evaluated, and the memory cell (15) is reset each time that the supply voltage is turned on.

4. An integrated circuit with a programmable locking circuit as claimed in Claim 1, **characterized in that** for the purpose of programming the gate (17) of one cell (1) and the source (18) of another cell (2) are driven simultaneously with an arbitrary programming pulse.

5. A portable data carrier with an integrated circuit as claimed in claim 1, which comprises regions with data to be protected, access to which from outside the data carrier being permanently prevented by means of said programmable locking circuit.

## Revendications

1. Circuit intégré avec circuit de bascule programmable pour la production d'un signal de commutation modifié de manière irréversible après programmation avec au moins deux cellules EEPROM (1, 2) dont les signaux de sortie donnent le signal de commutation après une liaison EXOR (5), dans lequel les cellules EEPROM (1, 2) ne sont programmables que simultanément de telle sorte qu'une cellule (1) est écrite et une autre (2) effacée,
**caractérisé en ce qu'**avant la programmation, une tension de grille de contrôle (16), qui est appliquée à une grille de contrôle des deux cellules EEPROM (1, 2), est respectivement modifiée jusqu'à ce que les mêmes signaux de sortie des deux cellules EEPROM (1, 2) soient rencontrés et que le signal de commutation ainsi atteint soit enregistré à titre intermédiaire dans une cellule de mémoire (15).

2. Circuit intégré avec circuit de bascule programmable selon la revendication 1,
**caractérisé en ce**
**qu'**après la programmation en cas d'application de différentes tensions de grille de contrôle (16) par les deux cellules (1,2) des signaux de sortie différents sont délivrés.

3. Circuit intégré avec circuit de bascule programmable selon la revendication 1,
**caractérisé en ce que** le signal de commutation dans la cellule de mémoire (15) est sauvé à titre intermédiaire et que le signal de sortie de la cellule de mémoire (15) est évalué et que la cellule de mémoire (15) est réinitialisée après chaque activation de la tension de fonctionnement.

4. Circuit intégré avec circuit de bascule programmable selon la revendication 1,
**caractérisé en ce**
**qu'**en vue de la programmation, une cellule est commandée à la grille (17) et une autre (2) simultanément à la source (18) avec une impulsion de programmation quelconque.

5. Support de données portable avec un circuit intégré selon la revendication 1 qui contient des zones avec des données à protéger auxquelles l'accès de l'extérieur du support de données est empêché durablement par le circuit de bascule programmé.
